(19) Europäisches Patentamt
European Patent Office
Office européen des brevets

(11) **EP 2 953 164 A1**

(12) **EUROPEAN PATENT APPLICATION**
published in accordance with Art. 153(4) EPC

(43) Date of publication:
**09.12.2015 Bulletin 2015/50**

(51) Int Cl.:
*H01L 23/36* (2006.01)   *C08J 5/18* (2006.01)
*H05K 7/20* (2006.01)

(21) Application number: **14745479.7**

(22) Date of filing: **17.01.2014**

(86) International application number:
**PCT/JP2014/050757**

(87) International publication number:
**WO 2014/119384 (07.08.2014 Gazette 2014/32)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **01.02.2013   JP 2013018727**

(71) Applicant: **Sumitomo Bakelite Company Limited**
**Shinagawa-ku**
**Tokyo 140-0002 (JP)**

(72) Inventors:
• **KOMIYATANI Toshio**
**Tokyo 140-0002 (JP)**
• **NAKANO Shogo**
**Tokyo 140-0002 (JP)**
• **KAWAGUCHI Tatsumi**
**Tokyo 140-0002 (JP)**

(74) Representative: **Ter Meer Steinmeister & Partner**
**Patentanwälte mbB**
**Nymphenburger Straße 4**
**80335 München (DE)**

(54) **HEAT CONDUCTING SHEET AND STRUCTURE**

(57)     Provided is a heat conductive sheet obtained by including a heat conductive filler in a cured organic resin, in which the heat conductive filler is made of multiple particles obtained by coating surfaces of plastic particles with a heat conductive material, and a coefficient of variation (CV) value of particle diameters of the particles, which is computed using Equation (1) described below, is equal to or less than 10%.

$$\text{CV value (\%) of particle diameters} = \text{standard deviation of particle diameters} / \text{arithmetic average particle diameter } d_n \times 100 \quad \dots (1)$$

FIG. 1

**Description**

TECHNICAL FIELD

The present invention relates to a heat conductive sheet and a structure.

BACKGROUND ART

There are known heat conductive sheets provided at joint interfaces at which high heat-conducting properties are required such as a joint interface between a heat-generating element such as a semiconductor chip and a heat-dissipating element such as a heat sink (Patent Documents 1 to 6).

In the method for manufacturing a heat conductive sheet described in Patent Documents 1 and 2, first, primary resin sheets in which the long axis direction of a heat conductive filler is oriented in the plane direction of the primary sheet are produced. After that, the primary sheets are laminated together so as to obtain a shaped body and then the shaped body is cured by heating. In addition, the shaped body is sliced in the lamination direction of the primary sheet, thereby obtaining a heat conductive sheet in which the long axis direction of the heat conductive filler is oriented in the thickness direction of the heat conductive sheet.

Patent Document 3 also describes the same manufacturing method as that of Patent Documents 1 and 2. However, the method for manufacturing a heat conductive sheet described in Patent Document 3 does not include a step of curing the shaped body by heating.

Furthermore, Patent Documents 4 and 5 describe heat conductive sheets including adhesive layer(s) on either or both surface(s) and Patent Document 6 describes heat conductive sheets including insulating layer(s) on either or both surface(s)

RELATED DOCUMENT

PATENT DOCUMENT

[Patent Document 1] Japanese Unexamined Patent Publication No. 2012-38763
[Patent Document 2] Japanese Unexamined Patent Publication No. 2011-162642
[Patent Document 3] Japanese Unexamined Patent Publication No. 2012-15273
[Patent Document 4] Japanese Unexamined Patent Publication No. 2012-109313
[Patent Document 5] Japanese Unexamined Patent Publication No. 2012-109312
[Patent Document 6] Japanese Unexamined Patent Publication No. 2011-230472

SUMMARY OF THE INVENTION

In the above-described manufacturing methods, the shaped body is obtained by laminating the primary sheets made of an uncured resin and thus the resin flows between the primary sheets and the flow of the resin disorganizes the orientation of the heat conductive filler. As a result, in the heat conductive sheet obtained using the above-described manufacturing method, there is a possibility that the heat-conducting properties may become insufficient in the thickness direction.

The present invention has been made in consideration of the above-described problem and provides a heat conductive sheet in which the orientation of the heat conductive filler is favorable and the heat-conducting properties are sufficient in the thickness direction.

According to the present invention, there is provided a heat conductive sheet obtained by including a heat conductive filler in a cured organic resin,

in which the heat conductive filler is made of multiple particles obtained by coating surfaces of plastic particles with a heat conductive material, and

a coefficient of variation (CV) value of particle diameters of the particles, which is computed using Equation (1) described below, is equal to or less than 10%,

$$\text{CV value (\%) of particle diameters} = \text{standard deviation of}$$

$$\text{particle diameters/arithmetic average particle diameter } dn \times 100 \dots$$

$$(1).$$

In addition, according to the invention of the present application, there is provided a structure including:

a pair of facing flat plates; and
the heat conductive sheet disposed between the pair of facing flat plates.

According to the present invention, a heat conductive sheet in which the orientation of a heat conductive filler is favorable and the heat-conducting properties are sufficient in the thickness direction is obtained.

BRIEF DESCRIPTION OF THE DRAWINGS

The above-described purpose and other purposes, characteristics, and advantages will be further clarified by preferred embodiments described below and the following drawings accompanied by the preferred embodiments.

FIG. 1 is a cross-sectional view of a heat conductive sheet according to the present embodiment.
FIG. 2 is a view showing an example of an apparatus for manufacturing a heat conductive filler according to the present embodiment.
FIG. 3 is a view showing an example of the apparatus for manufacturing a heat conductive filler according to the present embodiment.
FIG. 4 is a view showing an example of the apparatus for manufacturing a heat conductive filler according to the present embodiment.
FIG. 5 is a view showing an example of the apparatus for manufacturing a heat conductive filler according to the present embodiment.
FIG. 6 is a view showing an example of the apparatus for manufacturing a heat conductive filler according to the present embodiment.
FIG. 7 is a cross-sectional view of a structure according to the present embodiment.

DESCRIPTION OF EMBODIMENTS

Hereinafter, embodiments of the present invention will be described using the drawings. In all the drawings, the same components will be given the same reference numerals and description thereof will not be repeated.

<<Heat conductive sheet>>

A heat conductive sheet according to the present embodiment is obtained by including a heat conductive filler in a cured organic resin. The heat conductive filler is made of multiple particles obtained by coating the surfaces of plastic particles with a heat conductive material and the coefficient of variation (CV) value of the particles, which is computed using Equation (1) described below, satisfies specific conditions.

$$\text{CV value (\%) of particle diameters} = \text{standard deviation of}$$

$$\text{particle diameters/ arithmetic average particle diameter } dn \times 100$$

$$(1)$$

Specifically, the CV value of the diameters of the particles forming the heat conductive filler is equal to or less than 10%. When the CV value of the particle diameters is within the above-described specific range, the orientation of the heat conductive filler is favorable and it is possible to obtain sufficient heat-conducting properties in the thickness direction.

According to the present invention, regarding the particles forming the heat conductive filler, the CV value of the particle diameters is within the above-described specific range. Therefore, it is possible to control the particle diameters of the particles forming the heat conductive filler to become highly uniform. In addition, in a case in which the CV value of the particle diameters is within the above-described specific range, the heat conductive filler behaves like a gap material due to shaping pressure applied when the heat conductive sheet is attached to an adherend and thus it is possible to conduct heat through the shortest path in the thickness direction of the heat conductive sheet and the multiple particles are disposed in a state in which the contact between the adjacent particles in the heat conductive sheet is suppressed to the minimum extent by calculating the amount of the particles blended with the resin component. In addition, when the particles have highly uniform particle diameters as in the heat conductive filler according to the present embodiment, it is possible to make the thickness of the heat conductive sheet more uniform than in the related art. Furthermore, according to the heat conductive filler of the present embodiment, since the particle diameters of the particles constituting the heat conductive filler are highly controlled, it is possible to suppress the heat conduction resistance caused by the contact between the particles constituting the heat conductive filler to the minimum extent using a gap control effect. Meanwhile, in the heat conductive sheet according to the present embodiment, the heat conductive filler may be disposed so that adjacent particles are in contact with each other as described above or separated from each other in the sheet. The reasons therefor will be described below.

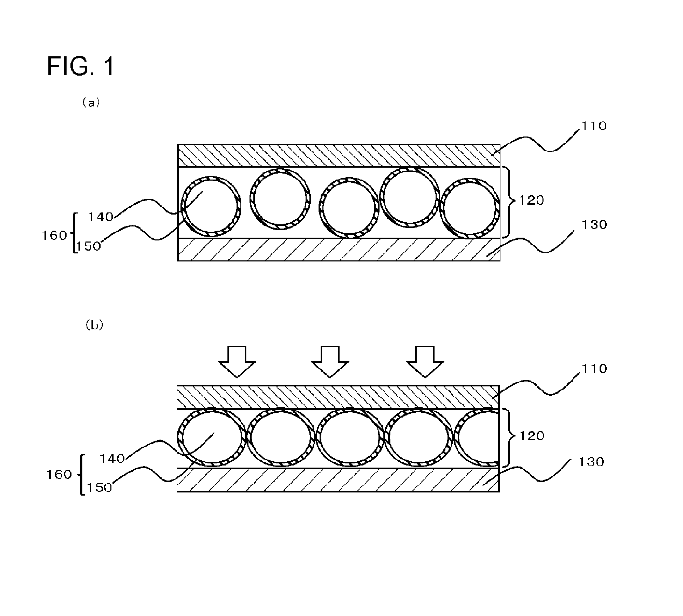

In addition, the heat conductive filler according to the present embodiment is flexible enough to be deformed (crushed by pressure) when, for example, a pressure of approximately 9.8 MPa is applied in the thickness direction of the heat conductive sheet formed using the heat conductive filler. When the heat conductive sheet 120 according to the present embodiment is attached to conductors (a first base material 110 and a second base material 130) by pressure, the heat conductive filler 160 obtained by coating the surfaces of the plastic particles 140 with the heat conductive material 150 is crushed by pressure due to shaping pressure. Therefore, the contact area with the conductors increases (FIG. 1). That is, heat conduction in a wide area in the thickness direction of the heat conductive sheet becomes possible and more favorable heat-conducting properties can be obtained.

In addition, according to the heat conductive filler of the present embodiment, since the particles have uniform particle diameters, it is possible to suppress the agglomeration between the fillers. In addition, in the heat conductive filler according to the present embodiment, since the surfaces of the plastic particles are coated with the heat conductive material, it is possible to suppress the amount of the heat conductive material used. As a result, it is possible to suppress the absorption of a solvent or moisture during the adjustment of varnish using aluminum oxide or boron nitride. Therefore, it is possible to suppress the generation of voids in the heat conductive sheet during shaping through heating and pressurizing.

In addition, in the heat conductive sheet according to the present embodiment, the plastic particles having the surfaces coated with the heat conductive material are used as the heat conductive filler. The heat conductive material according to the present embodiment is not particularly limited and may be, for example, at least one selected from the group consisting of aluminum nitride, boron nitride, aluminum oxide, aluminum, silicon nitride, zirconia, gold, magnesium oxide, and crystalline silica. Among them, the heat conductive material is preferably made of aluminum oxide and boron nitride.

Hereinafter, the heat conductive material according to the present embodiment which is made of aluminum oxide and/or boron nitride will be described using an example.

Aluminum oxide or boron nitride has excellent heat conductive properties. When the plastic particles, which are widely used in the semiconductor mounting field for their excellent heat resistance and chemical resistance and uniform particle size distribution, are coated using aluminum oxide and/or boron nitride, it is possible to obtain the heat conductive sheet having excellent heat conductive properties. In addition, according to the present embodiment, since the above-described heat conductive filler is used, the heat conductive sheet having a uniform thickness can be realized.

In addition, the plastic particles according to the present embodiment are formed of a crosslinked plastic material (for example, MICROPAL or the like manufactured by Sekisui Chemical Co., Ltd.). The crosslinked plastic material is not particularly limited and may be, for example, at least one selected from the group consisting of polystyrene, acrylic resins, phenolic resins, melamine resins, and synthetic rubber. Among them, polystyrene or synthetic rubber is preferred. In addition, the shape of the crosslinked plastic material is not particularly limited, but is preferably a spherical shape. In addition, the crosslinked plastic material may have a hollow structure.

In addition, regarding the multiple particles constituting the heat conductive filler according to the present embodiment, the CV value of the particle diameters is equal to or less than 10% and more preferably equal to or less than 5%. When the particles have the particle diameters in the above-described range, it is possible to realize the heat conductive sheet having favorable heat-conducting properties in the thickness direction.

In addition, regarding the multiple particles constituting the heat conductive filler according to the present embodiment, the arithmetic average particle diameter $d_n$ of the particles is preferably equal to or more than 20 $\mu$m and equal to or less than 150 $\mu$m and more preferably equal to or more than 30 $\mu$m and equal to or less than 100 $\mu$m. In such a case, it is possible to obtain the heat conductive sheet having more favorable heat-conducting properties and insulating properties (voltage resistance) in the thickness direction.

In addition, the particles forming the heat conductive filler according to the present embodiment preferably have a spherical shape. In such a case, even when the particles are deformed by the application of pressure as described above, the contact surfaces of the particles on both sides are capable of maintaining convex shapes and thus it is possible to suppress the contact area between the particles to the minimum extent. Therefore, it can be considered that the loss of heat conduction due to the contact between the particles can be reduced, furthermore, it is possible to increase the contact area with the conductors, and heat can be conducted through a shorter path in the thickness direction of the heat conductive sheet.

In addition, as described above, in the heat conductive sheet according to the present embodiment, the heat conductive filler may be disposed so that adjacent particles are in contact with each other or separated from each other in the sheet. In a case in which the heat conductive filler is disposed so that adjacent particles are separated from each other, the heat conductive filler is preferably disposed so that the content thereof reaches equal to or more than 50 volume% and equal to or less than 75 volume% per the total amount of the heat conductive sheet. In such a case, sufficient heat-conducting properties can be obtained in the thickness direction. In addition, it is possible to suppress the amount of aluminum oxide or boron nitride used. Therefore, it is possible to suppress the absorption of a solvent by aluminum oxide or boron nitride and suppress the generation of voids in the heat conductive sheet. In addition, according to the present embodiment, since the amount of aluminum oxide or boron nitride used can be suppressed, it is possible to suppress the amount of ammonia generated due to the hydrolysis of boron nitride, the generation of voids in the heat conductive sheet is suppressed, and the reliability of the obtained heat conductive sheet improves.

Hereinafter, the heat conductive sheet according to the present embodiment will be described in detail.

The material for the heat conductive filler according to the present embodiment needs to have favorable heat-conducting properties and be capable of maintaining a predetermined shape even after being subjected to a curing treatment of the organic resin.

In addition, in a case in which the heat conductive sheet is used for an application in which the heat conductive sheet does not need to have electric conductivity in the thickness direction, the heat conductive sheet may be an electrically insulating sheet. In a case in which the heat conductive sheet having electrical conductivity in the thickness direction is manufactured, an electrically conductive material is preferably used as the heat conductive filler. In a case in which an insulating heat conductive sheet is manufactured, an insulating material is preferably used as the heat conductive filler. Meanwhile, the electric conductivity in the thickness direction of the heat conductive sheet can be measured using, for example, the flash-annealing method.

In addition, the organic resin according to the present embodiment may be at least one selected from the group consisting of an epoxy resin, a polyimide, and benzoxazine. The epoxy resin may be a bisphenol A-type or bisphenol F-type epoxy resin. In a case in which the epoxy resin is used, the organic resin may include, for example, a curing agent such as imidazole, an amine, or a phenol compound.

In addition, the thickness of the heat conductive sheet according to the present embodiment can be set to, for example, equal to or more than 30 $\mu$m and equal to or less than 150 $\mu$m and preferably set to approximately 80 um. In such a case, it is possible to obtain the heat conductive sheet having more favorable heat-conducting properties and insulating properties (voltage resistance) in the thickness direction.

In addition, the heat conductivity of the heat conductive sheet according to the present embodiment in the thickness direction is preferably equal to or more than 10 W/m·K and more preferably equal to or more than 30 W/m·K. In such a case, it is possible to realize a superior heat conductive sheet. In addition, the upper limit value of the heat conductivity of the heat conductive sheet in the thickness direction is not particularly limited and an upper limit value of approximately equal to or less then 50 W/m·K is sufficient. Meanwhile, the heat conductivity of the heat conductive sheet according to the present embodiment in the thickness direction can be measured using, for example, the following method. First, the density of the heat conductive sheet is measured using the collecting-gas-over-water method, the specific heat is measured using differential scanning calorimetry (DSC), and furthermore, the thermal diffusivity coefficient is measured using the laser flash method. In addition, the heat conductivity of the heat conductive sheet in the thickness direction is computed from Equation (2) using the respective obtained measurement values.

$$\text{Heat conductivity (W/m·K)=density (kg/m}^3\text{)×specific heat}$$
$$\text{(kJ/kg·K)×thermal diffusivity coefficient (m}^2\text{/s)×1000 (2)}$$

The heat conductive sheet according to the present embodiment is provided at, for example, a joint interface at which high heat-conducting properties are required such as a joint interface between a heat-generating element (a semiconductor chip or the like) and a heat-dissipating element (a heat sink or the like) and accelerates the conduction of heat from the heat-generating element to the heat-dissipating element. Meanwhile, an example of the specific structure of a semiconductor device including the heat conductive sheets is a structure in which, for example, a semiconductor chip is mounted on a wiring substrate (interposer), the wiring substrate is mounted on a heat sink, and the heat conductive sheets are respectively provided at the joint interface between the semiconductor chip and the wiring substrate and at the joint interface between the wiring substrate and the heat sink.

In addition, in a case in which the heat conductive sheet according to the present embodiment is provided between the heat-generating element and the heat-dissipating element as described above and is heat-pressed in the thickness direction of the heat conductive sheet with, for example, a pressure of 9.8 MPa, the heat conductive filler is flexible enough to be crushed in the thickness direction of the heat conductive sheet as shown in FIG. 1(b).

Next, a method for manufacturing the heat conductive sheet in the present embodiment will be described.

In order to obtain the heat conductive sheet according to the present embodiment, it is necessary to obtain the heat conductive filler having a highly-controlled size. As the heat conductive filler according to the present embodiment, a heat conductive filler made of multiple particles obtained by coating the surfaces of the plastic particles with the heat conductive material is used as described above. However, it is difficult to obtain the heat conductive sheet in which the CV value of the particle diameters according to the present embodiment satisfies a specific condition using the methods of the related art described in the section of the background art. Specifically, the heat conductive sheet according to the present embodiment can be manufactured by highly controlling and combining individual factors together, such as the selection of an apparatus used when the surfaces of the plastic particles are coated, the amount of the heat conductive material supplied per unit time, the particle diameter ratio between the plastic particles and the heat conductive material, and the rotation speeds of the plastic particles. As described above, in order to obtain the heat conductive sheet in which the orientation of the heat conductive filler according to the present embodiment is favorable and the heat-conducting properties are sufficient in the thickness direction, it becomes particularly important to highly control the above-described factors.

Meanwhile, as an example of the method for manufacturing the heat conductive sheet according to the present embodiment, there is a method in which a powder treatment apparatus is used. However, the method for manufacturing the heat conductive sheet of the present embodiment is not limited thereto.

Hereinafter, the powder treatment apparatus used for the manufacturing of the heat conductive sheet will be described.

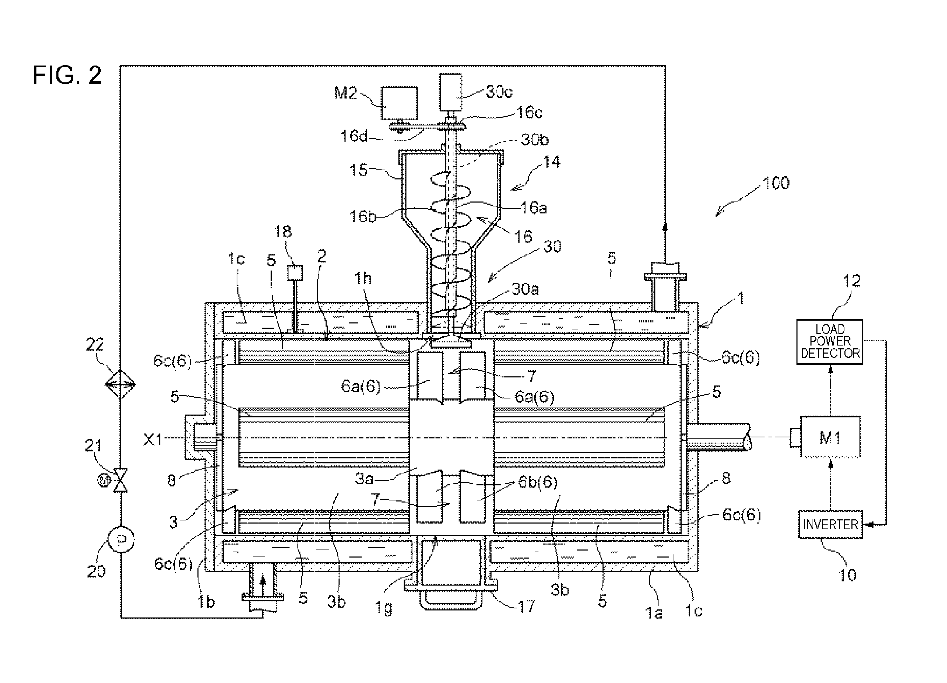

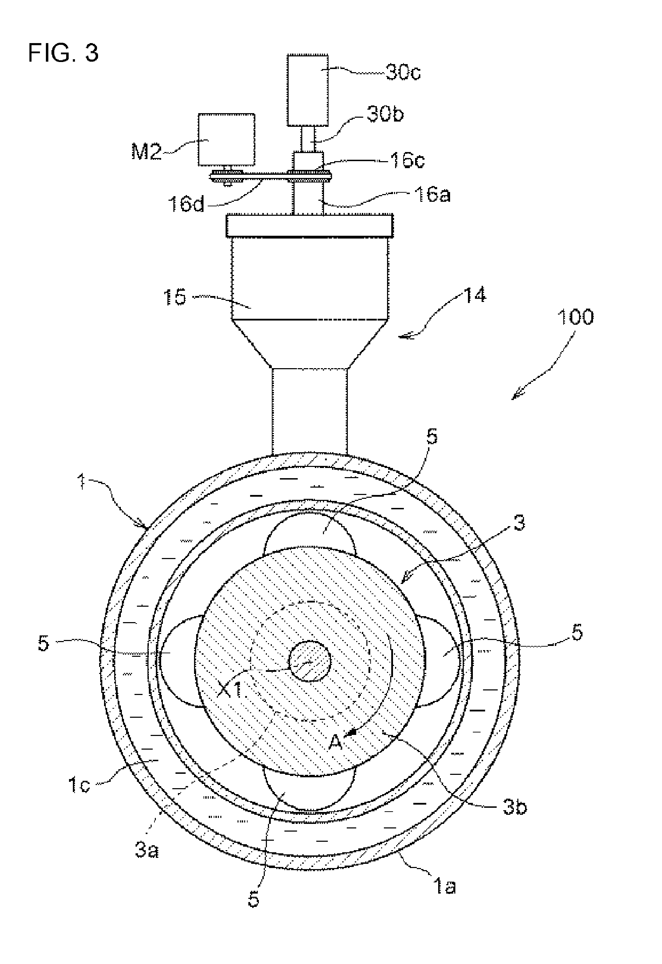

A powder treatment apparatus 100 shown in FIGS. 2 and 3 includes a horizontally long cylindrical casing 1 into which powder to be treated is injected, a rotor 2 supported so as to be capable of rotating around the horizontal axis center X1 of the casing 1, and a motor M1 that drives the rotor 2 to be rotated. The rotation number of the motor M1 is controlled through an inverter 10.

An opening section 1h through which the powder to be treated is supplied is formed in the upper section of the casing 1 in the powder treatment apparatus 100 and the powder to be treated can be supplied into the casing 1 from a supply device 14 installed in the opening section 1h. Meanwhile, the powder treatment apparatus 100 is constituted so as to treat powder in a batch mode.

<Rotor>

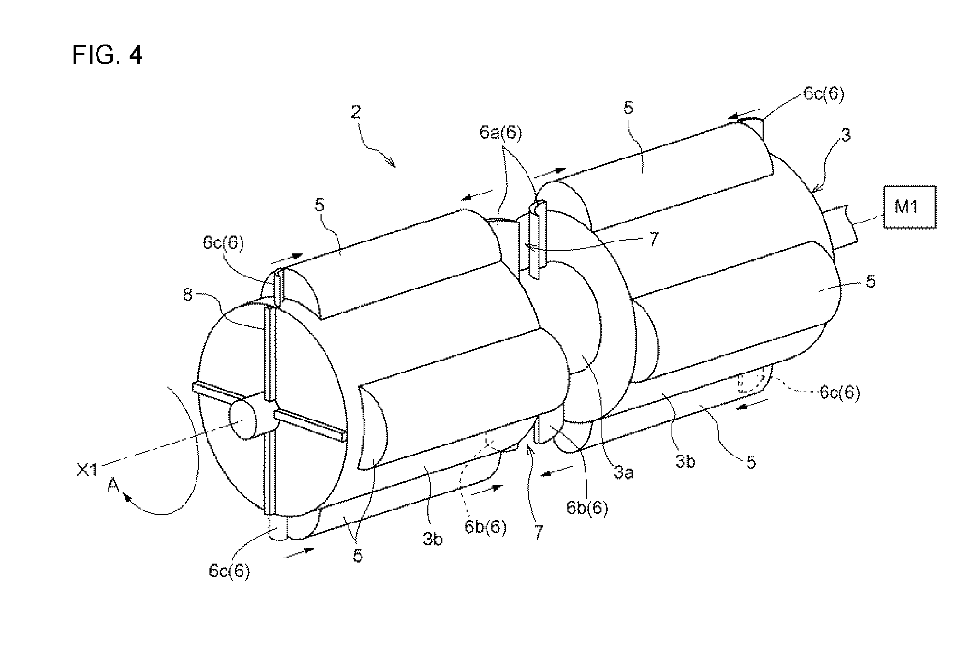

As shown in FIG. 4, the rotor 2 includes an approximately columnar shaft section 3 and the shaft section 3 is made up of one small-diameter section 3a, which is located near the center along the horizontal axis center X1, and a pair of large-diameter sections 3b, which extend forward and backward from the small-diameter section 3a. The opening section 1h is provided at a location facing the small-diameter section 3a.

On the outer circumferential surfaces of the respective large-diameter sections 3b, multiple convex blade sections 5 are provided so as to extend in the direction of the horizontal axis center X1 except for regions in which a location approximating to the motor M1 (hereinafter, referred to as "motor M1 side") and a location separating from the motor M1 (hereinafter, referred to as "opposite motor M1 side") are provided. In addition, regarding the shape of the blade section 5, the blade section is constituted using a part of a cylinder or elliptical cylinder having a smaller diameter than the large-diameter section 3b and the blade sections are capable of applying a strong compressive shearing force to the powder to be treated between the outer circumferences of the blade sections 5 and the inner surface of the casing 1 as the rotor 2 is driven to be rotated by the motor M1. The blade sections 5 can be integrally shaped with the shaft section 3, but it is also possible to join the blade sections 5, which are separate bodies, to the outer circumference of the shaft section 3 through welding or the like.

In the example of FIG. 4, the blade sections 5 disposed on the motor M1 side and the blade sections 5 disposed on the opposite motor M1 side are disposed in the same angular phase, but the blade sections 5 on the motor M1 side and the blade sections 5 on the opposite motor M1 side may be disposed in different angular phases.

Furthermore, according to the powder treatment apparatus 100, it is possible to impart a moving force by which the powder to be treated is actively moved along the horizontal axis center X1 by disposing the blade sections 5 inclined against the horizontal axis center X1. In addition, each of the blade section 5 may be divided into two or more pieces along the horizontal axis center X1. When the blade sections are divided, it is possible to reduce the loads on the blade sections 5, the rotor 2, and the like by dispersing the force applied to the respective blade sections 5.

In addition, in order to suppress the generation of vibration caused by the rotation of the rotor 2, the blade sections 5 are disposed in a rotational symmetric manner with respect to the horizontal axis center X1, in other words, so that all the intervals between the adjacent blade sections 5 become equal. As a result, when the number of the blade sections 5 is represented by N and the angle formed by two adjacent blade sections 5 disposed in the circumferential direction is represented by θ, θ=360/N (here, N≥2) is satisfied. In FIG. 2, four blade sections 5 are provided at angular intervals of 90°, but it is also possible to provide an arbitrary number, such as two, three, or five, of blade sections 5. Meanwhile, the number of the blade sections 5 is appropriately determined depending on the purpose of the treatment, the particle diameter and other characteristics of the powder to be treated, the overall size of the powder treatment apparatus, the material constituting the blade sections 5, and the like.

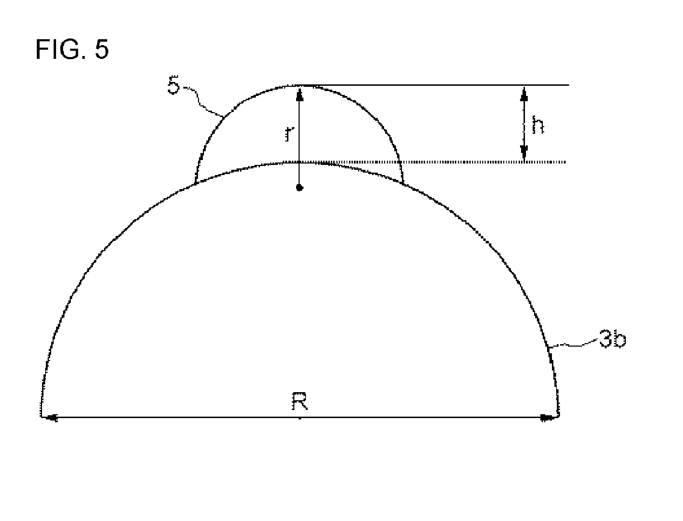

As shown in FIG. 5, when the radius of an arc constituting the cross-sectional shape of the blade section 5 is represented by r, the height from the large-diameter section 3b to the front end of the blade section 5 is represented by h, and the outer diameter of the large-diameter section 3b of the shaft section 3 is represented by R, r and h are determined so that r satisfies a mathematical expression of $(2r/R)<1$ and h satisfies a mathematical expression of $(h/R)<0.5$. The apparatus 100 shown in FIG. 2 is constituted so that the relationship $(R:r:h=5:1:0.7)$ is satisfied. The gap between the front end of the blade section 5 in the diameter direction and the arc-shaped inner surface of the casing 1 is set to a range of approximately 0.5 mm to 5.0 mm.

On the outer circumferential surface of the small-diameter section 3a in the center and both far end regions of the large-diameter sections 3b on the motor M1 side and the opposite motor M1 side, multiple deflection paddles 6 (an example of deflection means) are provided so as to extend outward in the diameter direction instead of the blade sections 5. The deflection paddle 6 on the small-diameter section 3a is made up of a sending paddle 6a that is inclined against the horizontal axis center X1 so as to send the powder to be treated located near the center along the horizontal axis center X1 toward the right and left blade sections 5 and a returning paddle 6b that is inclined so as to guide the powder to be treated located near the right and left blade sections 5 near the center. The relatively short inclined deflection paddles 6c in the end regions are constituted so as to send the powder to be treated located at both ends of the shaft section 3 toward the right and left blade sections 5 when the rotor 2 is rotated clockwise (represented by an arrow A) on the basis of the left side of the rotor in FIG. 4.

The respective numbers of the paddles 6a, 6b, and 6c disposed in the respective regions, the material constituting the paddles 6, and the like are appropriately determined depending on the size of the powder treatment apparatus, the purpose of the treatment, the material and particle diameter of the powder to be treated, other characteristics of the powder to be treated, and the like.

Linear fins 8 (an example of a returning member) are provided so as to extend on both end surfaces of the rotor 2. Even when the powder to be treated comes into the gap between both end surfaces of the rotor 2 and the casing 1, the powder to be treated is pushed back to the outer circumferential section of the rotor 2 by the fins 8 and thus there is no case in which untreated or insufficiently treated powder to be treated remains in the same gap. The gap between the front end of the fin 8 and the side surface of the casing 1 is set to approximately 0.5 mm in the direction of the horizontal axis center X1.

<Supply device>

The supply device 14 carries out a function of supplying the powder to be treated to the casing 1 before the operation of the powder treatment apparatus 100 is initiated (an example of a supply step) and a function as supplementation means for supplementing the powder to be treated as much as the apparent volume of the powder to be treated decreased due to actions such as mixing, crushing, synthesis, coating, and surface deforming (which are all examples of a treatment step) occurring to the powder to be treated due to the rotor driven to be rotated (an example of a powder supplementation step).

The supply device 14 includes a hopper 15 which is capable of storing the powder to be treated (an example of a raw material chamber) and a screw 16 which extends toward the opening section 1h from the lower section of the hopper 15 (an example of pressing means). The screw 16 is appropriately driven using a screw blade 16b fixed to a cylindrical shaft 16a which constitutes the screw 16, a pulley 16c attached to the upper end of the shaft 16a, and a motor M2 which drives an endless belt 16d wound around the pulley 16c to be rotated.

Around the location of the small-diameter section 3a, since no blade section 5 is provided and a large space is formed on the inner surface of the casing 1, the effect of a compressive shearing force is not well exhibited but a buffer region 7 (an example of a storage region) for smoothly receiving and storing the powder to be treated from the opening section 1h is constituted. The powder to be treated fed into the buffer region 7 is sent to powder treatment regions present in the right and left blade sections 5 using the sending paddle 6a. At this time, the powder to be treated previously existing in the powder treatment regions is alternatively moved into the buffer region 7 and thus, in the powder treatment through a compressive shearing treatment, a series of operations in which the powders to be treated having different treatment degrees are mixed with each other in the buffer region 7 and some of the powder is again moved toward the blade sections 5 are continuously carried out.

<Control unit>

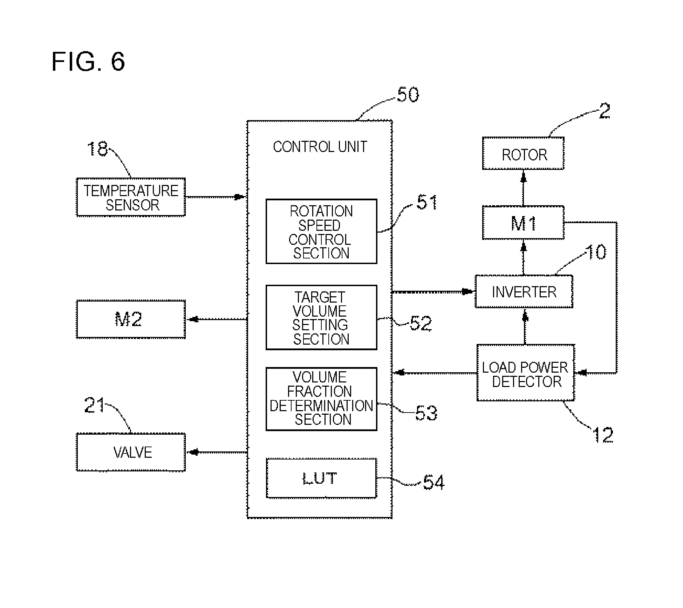

A control unit 50 that controls the driving of the respective sections of the powder treatment apparatus 100 is shown in FIG. 6. The control unit 50 includes a rotation speed control section 51 that controls the rotation speed of the rotor 2 on the basis of the treatment purpose of the powder to be treated, the operation status of the powder treatment apparatus 100, and the like, a target volume setting section 52 that sets the volume fraction of the powder to be treated in the casing 1, a volume fraction determination section 53 that determines the actual volume fraction of the powder to be treated in the casing 1, and the like.

When the treatment purpose of the powder to be treated is input to a computer connected to the powder treatment apparatus 100 from a keyboard or the like, the rotation speed control section 51 sets the basic rotation speed of the rotor 2 which is suitable for the treatment purpose and the motor M1 is driven to be rotated through the inverter 10. At this time, a volume fraction suitable for the treatment purpose is also set in the target volume setting section 52. Next, when the determination result from the volume fraction determination section 53 during the rotary driving of the motor M1 is below the volume fraction (an example of the predetermined value of the volume fraction) set by the target volume setting section 52, the screw 16 is driven by the motor M2 and thus a deficient amount of the powder to be treated is supplemented to the buffer region 7.

The volume fraction determination section 53 (an example of determination means) determines the volume fraction on the basis of the detection result from a load power detector 12 (an example of determination means) which detects the load power of the motor M1 that drives the rotor 2 to be rotated. The determination is made with reference to LUT54 produced on the basis of a variety of previously measured experimental results. In principle, the decreasing tendency of the load power corresponds to the decrease in the volume fraction.

The powder to be treated may be supplemented in a state in which the rotor 2 is stopped or while the treatment by the rotary driving of the rotor 2 is continued. In any cases, the treatment by the rotary driving of the rotor 2 is continued even after the supplementation of the powder to be treated. Generally, a series of operations made up of a powder supplementation step and treatment steps after the supplementation are repeated multiple times until the treatment of the powder to be treated as much as previously set as the amount of the powder treated in a batch is finished.

In addition, the control unit 50 may determine whether or not the intended treatment is completed on the powder to be treated on the basis of the determination result from the volume fraction determination section 53 and then stop the driving of the rotor 2 on the basis of the above-described determination.

It is also possible to provide a temperature sensor 18 which measures the temperature near the inner surface of the casing 1 at a part of the casing 1 and control the rotation number of the rotor 2 so as to prevent the casing 1 or the rotor 2 from being damaged due to overheating.

In addition, it is also possible to allow the rotation speed control section 51 to control the rotation number of the rotor 2 on the basis of the change in the load power alone. That is, it is also possible to carry out a powder control method in which the rotation speed control section 51 controls the rotation number of the rotor 2 so that the load power on the motor M1 which drives the rotor 2 approximates to a certain value (for example, 8 kW).

On the outer circumference of the casing 1, a jacket 1c which circulates a fluid such as water for the adjustment of temperature is provided and cooling water or the like is made to flow into the jacket. In the circulation path, a pump 20 that sends out cooling water, an operation valve 21 that controls the flow rate of the cooling water, and a heat exchanger 22 that cools the cooling water are interposed. It is also possible to allow the control unit 50 to adjust the opening of the operation valve 21 on the basis of the measured temperature value from the temperature sensor 18 so as to automatically control the temperature of the casing 1 to a certain extent.

<Valve>

In the opening section 1h, a valve 30 capable of opening and closing the opening section 1h may be provided. The valve 30 shown in the drawing penetrates through the inside of the shaft 16a of the screw 16 and includes a rod 30b that is pivotally supported by the shaft 16a, a valve body 30a fixed to the lower end of the rod 30b, and an actuator 30c for vertically moving the valve body 30a through the rod 30b. The valve body 30a can be switched between the lower closing location and the upper opening location using the actuator 30c. During the treatment of the powder to be treated by the rotor 2, basically, the valve body 30a is maintained at the closing location and the valve body 30a is switched to the opening location only when the powder is supplemented. The lower surface of the valve body 30a has a shape in which the lower surface coincides with the inner surface of the casing 1 so that the opening section 1h is sealed when the valve body 30a is present at the closing location. In addition, the upper surface of the valve body 30a has a tapering shape so that the powder to be treated can be smoothly supplemented from the opening section 1h when the valve body 30a is present at the opening location. The actuator 30c can be constituted using an air cylinder and may be constituted using an electric cylinder, a hydraulic cylinder, or the like.

When the opening section 1h is closed using the valve 30 and then the treated powder is collected from the casing 1 after the stoppage of the rotor 2, there is no concern that untreated powder to be treated and the like in the screw 16 may be dropped and mixed with treated powder. Furthermore, even during the rotation of the rotor 2, it is possible to prevent untreated powder to be treated in the screw 16 from carelessly being mixed with treated powder by maintaining the opening section closed by the valve 30 while there is no need to supplement the powder to be treated.

On the lower surface of the casing 1, a round lower section opening 1g which remains sealed by a sealing lid 17 throughout the treatment is formed. The lower section opening 1g is provided in the buffer region 7 and, when treated powder is discharged and collected, the majority of the treated powder can be collected through the lower section opening 1g by rotating or inversely rotating the rotor 2 in a state in which the sealing lid 17 is removed. In order to ensure the sealing between the lower section opening 1g and the sealing lid 17, it is possible to provide a tapering shape so that the diameter of the side surface section of the sealing lid 17 decreases upward or provide packing expanded using a pressurizing gas on the upper surface of the sealing lid 17.

The casing 1 is made up of a cylindrical casing main body 1a having an inner surface that faces the outer circumference of the rotor 2 and a cover section 1b that closes the open section of the casing main body 1a on the opposite motor M1 side. When the cover section 1b that closes the casing main body 1a is removed and the rotor 2 is separated from the axis of the motor M1 and is pulled away from the casing main body 1a toward the left side of FIG. 2, powder attached to the inner surface of the rotor 2 or the casing 1 can be removed.

Therefore, it is possible to apply the heat conductive material to the surfaces of the plastic particles while the plastic particles are rotated. Therefore, it is possible to control the particle diameters of the particles forming the heat conductive filler to become highly uniform.

The method for manufacturing the heat conductive sheet according to the present embodiment includes the following steps (A) to (C).

(A) A step of producing a heat conductive filler made of multiple particles obtained by coating the surfaces of the plastic particles with the heat conductive material.

(B) A step of obtaining a kneaded substance by kneading the heat conductive filler obtained in (A) with the organic resin.

(C) A step of obtaining a heat conductive sheet by applying the kneaded substance obtained in (B) onto a substrate in a thin film shape, putting the kneaded substance into the B-stage, and then hot-pressing the kneaded substance.

First, a heat conductive filler obtained by controlling the particle diameters to become highly uniform is prepared using the above-described method (the above-described step (A)).

Next, an organic resin which is yet to be cured or semi-cured and the heat conductive filler made of multiple particles are mixed together and are kneaded together so that the heat conductive filler is uniformly present in the organic resin. Hereinafter, the substance obtained by kneading the organic resin and the heat conductive filler made of a number of particles will be referred to as the kneaded substance (or the resin composition) (the above-described step (B)).

In addition, the obtained kneaded substance is applied onto a substrate and then is hot-pressed, thereby obtaining a heat conductive sheet. At this time, there is no particular limitation regarding the method for applying the kneaded substance and, for example, methods such as the spin coating method, the screen printing method, the die coater method, the bar coater method, and the gravure coater method can be used. In such a case, it is possible to obtain a heat conductive sheet having a uniform thickness (the above-described step (C)).

«Structure»

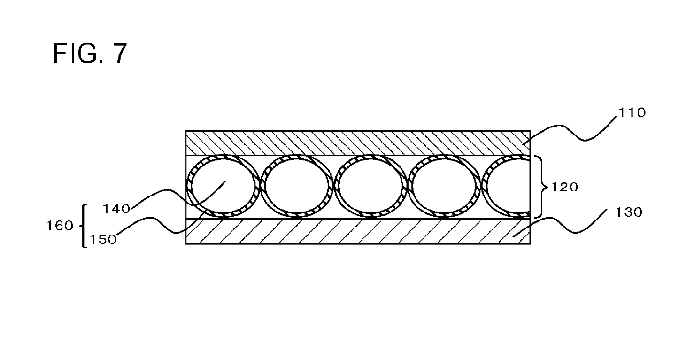

FIG. 7 is a cross-sectional view of a structure according to the present embodiment.

As shown in FIG. 7, the structure according to the present embodiment includes a pair of facing flat plates and the above-described heat conductive sheet according to the present embodiment disposed between the pair of facing flat plates.

For the multiple particles included in the heat conductive sheet in the structure according to the present embodiment, the CV value of the particle diameters is in the above-described specific range. As described above, the particles according to the present embodiment are controlled so that the particle diameters become uniform. Therefore, it is also possible to make the particles function as a spacer filling a space between the pair of facing flat plates. That is, the heat conductive filler in the structure according to the present embodiment can be made to function as a heat-dissipating spacer.

Meanwhile, the pair of facing flat plates in the structure according to the present embodiment is preferably made up of a heat-generating element (a semiconductor chip or the like) and a heat-dissipating element (a heat sink or the like).

Thus far, the embodiments of the present invention have been described, but the embodiments are simply examples of the present invention and thus it is also possible to employ a variety of constitutions other than what has been described above.

Examples

Hereinafter, the present embodiment will be described in detail with reference to examples and comparative examples. Meanwhile, the present invention is not limited by any means to the description of the examples.

(Manufacturing Example 1)

<Manufacturing of heat conductive filler>

First, a heat conductive filler was obtained by coating the surfaces of plastic particles (MICROPAL manufactured by Sekisui Chemical Co., Ltd.) with hexagonal boron nitride (UHP-1K manufactured by Showa Denko K.K. , average particle diameter of 8 $\mu$m) using a powder treatment apparatus (NOBILTA manufactured by Hosokawa Micron Corporation). The powder treatment apparatus included a casing that received powder to be treated, a rotor which was rotated in relation to the casing and had blade sections provided on the outer circumference so as to apply a compressive shearing force to the powder to be treated between the inner surface of the casing and the blade sections, and supplementation means that supplemented the powder to be treated to the inside of the casing so that the volume fraction of the powder to be treated in the casing was maintained at equal to or more than a predetermined value after the initiation of the relative rotation.

Specifically, first, the plastic particles were set in the casing of the powder treatment apparatus. Next, powder-form boron nitride was supplied to the casing and the rotor was driven to be rotated. Therefore, the surfaces of the plastic particles were coated with boron nitride and a spherical heat conductive filler was obtained. Meanwhile, the rotor was driven at 5000 rpm for 15 minutes with a water cooling control so that the temperature near the inner surface of the casing did not reach equal to or higher than 50°C.

In addition, as the plastic particles, particles having a CV value of the particle diameters of 3% and an arithmetic average particle diameter dn of 30 $\mu$m were used.

(Manufacturing Example 2)

A heat conductive filler was manufactured using the same method as in Example 1 except for the fact that particles having a CV value of the particle diameters of 3% and an arithmetic average particle diameter dn of 60 $\mu$m were used as the plastic particles.

(Manufacturing Example 3)

A heat conductive filler was manufactured using the same method as in Example 1 except for the fact that particles having a CV value of the particle diameters of 10% and an arithmetic average particle diameter dn of 90 $\mu$m were used as the plastic particles.

(Comparative Manufacturing Example 1)

As the heat conductive filler, the plastic particles were not used and hexagonal boron nitride (UHP-2 manufactured by Showa Denko K.K.) having an arithmetic average particle diameter dn of 12 $\mu$m was solely used at a blending content of 60%.

(Comparative Manufacturing Example 2)

As the heat conductive filler, the plastic particles were not used and alumina (LS-130 manufactured by Nippon Light Metal Company, Ltd.) having an arithmetic average particle diameter dn of 2.2 $\mu$m was solely used at a blending content of 60%.

<Manufacturing of heat conductive sheet>

First, the heat conductive filler of Manufacturing Example 1 and a B-stage epoxy resin were kneaded together. Meanwhile, the components were kneaded using a disperser.

Next, the obtained kneaded substance was applied onto a substrate using a spin coater, was treated at 120°C for 15 minutes using a dryer, and thus was put into the B-stage. After that, the substrate sandwiched by the kneaded substance was pressed using a press machine for 30 minutes under conditions of a tool pressure of 8 MPa and a tool temperature of 180°C, thereby obtaining a heat conductive sheet of Example 1.

Meanwhile, heat conductive sheets were produced using the same method and the heat conductive fillers of Manufacturing Examples 2 and 3 and Comparative Manufacturing Examples 1 and 2. The heat conductive sheet obtained using the heat conductive filler of Manufacturing Example 2 was used as a heat conductive sheet of Example 2 and the heat conductive sheet obtained using the heat conductive filler of Manufacturing Example 3 was used as a heat conductive sheet of Example 3. In addition, the heat conductive sheet obtained using the heat conductive filler of Comparative Manufacturing Example 1 was used as a heat conductive sheet of Comparative Example 1 and the heat conductive sheet obtained using the heat conductive filler of Comparative Manufacturing Example 2 was used as a heat conductive sheet of Comparative Example 2.

Each of the obtained heat conductive sheets of the examples and the comparative examples was provided between a semiconductor chip and a heat sink and was heat-pressed in the thickness direction of the heat conductive sheet with a pressure of 9.8 MPa. Therefore, it was confirmed that the heat conductive filler was flexible enough to be crushed in the thickness direction of the heat conductive sheet.

<Evaluation method>

Particle size distribution: The particle size distribution of the obtained heat conductive filler was measured using a laser diffraction particle size analyzer (SALD-7000 manufactured by Shimadzu Corporation). The unit thereof was $\mu$m.

The CV value of the particle diameters was computed from the measurement result of the particle size distribution using Equation (1) described below. The unit thereof was %.

$$\text{CV value (\%) of particle diameters= standard deviation of particle diameters/ arithmetic average particle diameter } dn \times 100 \quad (1).$$

Heat conductivity: For each of the heat conductive sheets obtained in the examples and the comparative examples, the density was measured using the collecting-gas-over-water method, the specific heat was measured using differential scanning calorimetry (DSC), and furthermore, the thermal diffusivity coefficient was measured using the laser flash method. In addition, for each of the heat conductive sheets obtained in the examples and the comparative examples, the heat conductivity in the thickness direction was computed from Equation (2) described below.

$$\text{Heat conductivity (W/m·K)=density (kg/m}^3)\times\text{specific heat (kJ/kg·K)}\times\text{thermal diffusivity coefficient (m}^2/\text{s)}\times 1000 \quad (2)$$

The evaluation results regarding the above-described evaluation items are described in Table 1 below.

[Table 1]

|  | Example 1 | Example 2 | Example 3 | Comparative Example 1 | Comparative Example 2 |
|---|---|---|---|---|---|
| CV value of particle diameters of particles forming heat conductive fillers [%] | 5 | 5 | 5 | 20 | 15 |
| Arithmetic average particle diameter dn of particles forming heat conductive fillers [$\mu$m] | 32 | 62 | 92 | 12 | 2.2 |
| Heat conductivity in thickness direction [W/m·K] | 18 | 15 | 13 | 0.5 | 3 |

The CV values of the particle diameters of the particles forming the heat conductive fillers of the examples were all smaller than the values of the comparative examples. Actually, in a case in which a heat conductive sheet was manufactured using the particles described in the examples, a heat conductive sheet in which the orientation of the heat conductive filler was favorable and the heat-conducting properties were sufficient in the thickness direction was obtained.

The present application claims a priority on the basis of Japanese Patent Application No. 2013-018727 filed on February 1, 2013 and the content thereof is incorporated herein by reference.

## Claims

1. A heat conductive sheet comprising a heat conductive filler included in a cured organic resin,
   wherein the heat conductive filler is made of multiple particles obtained by coating surfaces of plastic particles with a heat conductive material, and
   a coefficient of variation (CV) value of particle diameters of the particles, which is computed using Equation (1) described below, is equal to or less than 10%,

   $$\text{CV value (\%) of particle diameters} = \text{standard deviation of particle diameters} / \text{arithmetic average particle diameter } dn \times 100 \quad \dots (1).$$

2. The heat conductive sheet according to Claim 1,
   wherein the arithmetic average particle diameter dn of the particles is equal to or more than 20 $\mu$m and equal to or less than 150 $\mu$m.

3. The heat conductive sheet according to Claim 1 or 2,
   wherein the heat conductive filler is spherical.

4. The heat conductive sheet according to any one of Claims 1 to 3,
   wherein the heat conductive material is formed of at least one selected from a group consisting of aluminum nitride, boron nitride, aluminum oxide, aluminum, silicon nitride, zirconia, gold, magnesium oxide, and crystalline silica.

5. The heat conductive sheet according to any one of Claims 1 to 4,
   wherein the plastic particles are formed of a crosslinked plastic material.

6. The heat conductive sheet according to Claim 5,
   wherein the crosslinked plastic material is at least one selected from polystyrene, acrylic resins, phenolic resins, melamine resins, and synthetic rubber.

7. The heat conductive sheet according to any one of Claims 1 to 6,
   wherein a heat conductivity in a thickness direction is equal to or more than 10 W/m·K and equal to or less than 50 W/m·K.

8. The heat conductive sheet according to any one of Claims 1 to 7,
   wherein the organic resin is at least one selected from a group consisting of an epoxy resin, a polyimide, and benzoxazine.

9. The heat conductive sheet according to any one of Claims 1 to 8,
   wherein the heat conductive sheet is provided between a heat-generating element and a heat-dissipating element, and
   in a case in which the heat conductive sheet is provided between the heat-generating element and the heat-dissipating element and is heat-pressed in the thickness direction of the heat conductive sheet with a pressure of 9.8 MPa, the heat conductive filler is flexible enough to be crushed in the thickness direction.

10. The heat conductive sheet according to Claim 9,
    wherein the heat-generating element is a semiconductor chip.

**11.** The heat conductive sheet according to Claim 9 or 10,
wherein the heat-dissipating element is a heat sink.

**12.** A structure comprising:

a pair of facing flat plates; and
the heat conductive sheet according to any one of Claims 1 to 11 disposed between the pair of facing flat plates.

**13.** The structure according to Claim 12, wherein the pair of facing flat plates is made up of a heat-generating element
and a heat-dissipating element.

**14.** The structure according to Claim 13,
wherein the heat-generating element is a semiconductor chip.

**15.** The structure according to Claim 13 or 14,
wherein the heat-dissipating element is a heat sink.

# FIG. 1

(a)

(b)

FIG. 2

FIG. 3

FIG. 4

EP 2 953 164 A1

FIG. 5

FIG. 6

## FIG. 7

<table>
<tr><td colspan="3"><b>INTERNATIONAL SEARCH REPORT</b></td><td colspan="2">International application No.<br>PCT/JP2014/050757</td></tr>
</table>

**A. CLASSIFICATION OF SUBJECT MATTER**
*H01L23/36*(2006.01)i, *C08J5/18*(2006.01)i, *H05K7/20*(2006.01)i

According to International Patent Classification (IPC) or to both national classification and IPC

**B. FIELDS SEARCHED**

Minimum documentation searched (classification system followed by classification symbols)
H01L23/36, C08J5/18, H05K7/20

Documentation searched other than minimum documentation to the extent that such documents are included in the fields searched
Jitsuyo Shinan Koho          1922–1996   Jitsuyo Shinan Toroku Koho   1996–2014
Kokai Jitsuyo Shinan Koho    1971–2014   Toroku Jitsuyo Shinan Koho   1994–2014

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2011-35221 A  (JSR Corp.),<br>17 February 2011 (17.02.2011),<br>paragraphs [0003], [0026]<br>(Family: none) | 1-15 |
| Y | JP 2012-140625 A  (Nitto Denko Corp.),<br>26 July 2012 (26.07.2012),<br>paragraph [0141]<br>(Family: none) | 1-15 |
| Y | JP 2001-274302 A  (JSR Corp.),<br>05 October 2001 (05.10.2001),<br>paragraphs [0032] to [0035]<br>(Family: none) | 1-15 |

☐  Further documents are listed in the continuation of Box C.          ☐  See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered  to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>08 April, 2014 (08.04.14) | Date of mailing of the international search report<br>15 April, 2014 (15.04.14) |
|---|---|
| Name and mailing address of the ISA/<br>Japanese Patent Office | Authorized officer |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012038763 A
- JP 2011162642 A
- JP 2012015273 A
- JP 2012109313 A
- JP 2012109312 A
- JP 2011230472 A
- JP 2013018727 A